# EUROPEAN PATENT APPLICATION

(11) **EP 1 274 149 A2**
(43) Date of publication of application: **08.01.2003**
(21) Application number: 02012482.2
(22) Date of filing: 12.06.2002
(51) Int. Cl.: H01P 5/107, H01P 11/00

(54) **Radio frequency circuit manufacturing method and radio frequency circuit**

(30) Priority: 05.07.2001 JP 2001204331; 05.04.2002 JP 2002103297
(71) Applicant: MATSUSHITA ELECTRIC INDUSTRIAL CO., LTD., Kadoma-shi, Osaka 571-8501 (JP)
(72) Inventor: Ogura, Hiroshi, Machida-shi, Tokyo 195-0061 (JP); Takahashi, Kazuaki, Machida-shi, Tokyo 195-0053 (JP)
(74) Representative: Balsters, Robert

(57) **Abstract**

Disclosed is a radio frequency circuit having a membrane structure and manufacturing method for the same. The radio frequency circuit has a circuit element formed on an insulating material plate having copper bonded on both surfaces or one surface thereof whereby a metal substrate having a hollow bore and the insulating material plate forming the circuit element are bonded together. The circuit element is mounted with an active element on which a lid having a partition wall is bonded for packaging. The hollow bore in the metal substrate, for forming a membrane structure, is formed by press-blanking. Because the metal substrate is not wet-etched, dimensions control can be easily, precisely made on a hollow bore region of the metal substrate. Furthermore, it is possible to shorten the working time on the hollow bore region.

## Description

### FIELD OF THE INVENTION

The present invention relates to a radio frequency circuit manufactured by using a metal-core substrate having an insulating material laminated on a metal substrate such as of copper or aluminum or the like and, more particularly, to a manufacturing method for a radio frequency circuit on a high frequency range of a microwave or millimeter-wave band and to such a radio frequency circuit.

### BACKGROUND OF THE INVENTION

The metal-core substrate having an insulating material laminated on a metal substrate such as of copper or aluminum, known as a radio frequency circuit substrate, is marketed under the product name of Diacore by Mitsubishi Resin. The radio frequency circuit manufactured by the use of such a metal-core substrate allows heat dissipation from the metal substrate. Thus, a radio frequency circuit can be manufactured having high heat dissipation characteristic. In the case of manufacturing a radio frequency circuit using a metal-core substrate, the copper or aluminum uses a thickness of nearly 100 µm or greater, generally approximately 500 µm-3 mm, from the relationship of connection with a housing accommodating the radio frequency circuit.

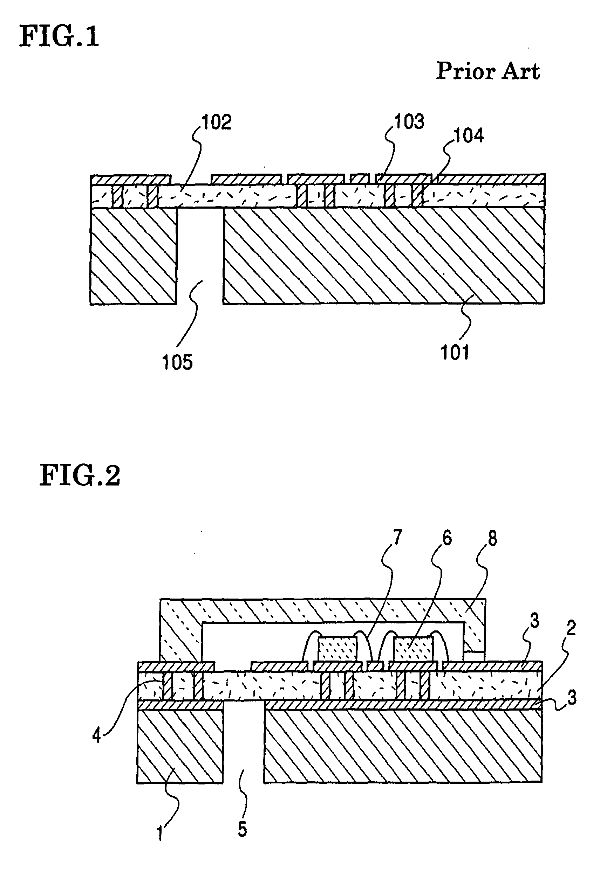

Fig. 1 shows an example of a radio frequency circuit utilizing a metal-core substrate. This radio frequency circuit is structured with an insulating material 102 having a low dielectric loss formed on a metal substrate 101, such as of copper or aluminum, a transmission line 103 formed on the insulating material 102, and a through-hole 104 formed with a conductor to electrically, thermally conductively connect between the metal substrate 101 and the transmission line 103. When fabricating a radio frequency circuit on a high frequency range of a microwave or millimeter-wave band, the insulating material 102 is selected with a material having a low dielectric loss (low dielectric loss tangent) characteristic, such as polyimide or teflon, in order to reduce the dielectric loss over the transmission line.

In order to make the radio frequency circuit in a membrane structure, a hollow bore 105 is formed in the metal substrate 101. Meanwhile, it is possible to connect a waveguide transmitting a signal inputted from an antenna to the hollow bore 105, thereby structuring a converter for converting a membrane-structured circuit portion from the waveguide into a planar circuit.

However, in the case of forming a hollow bore 105 in the metal substrate 101, it is a general practice to form a mask on the substrate 101 to carry out etching thereby forming a hollow bore 105. Generally, it is difficult to form a hollow bore 105 into a desired form. Namely, the hollow bore 105 would be isotropic in form and etched to a somewhat inward of a mask. Furthermore, when the metal substrate 101 has a thickness of 1 mm, it requires a working time of 3 hour and 20 minutes provided that the etching rate on the metal substrate 101 is 5 µm/min. Thus, the method cannot be considered an efficient working method.

Meanwhile, there is a method that a hollow bore 105 is previously provided in a metal substrate 101 to hot-press an insulating material 102. In this method, however, the insulating material 102 flows in the hollow bore 105 of the metal substrate 101 thereby making it difficult to obtain a favorable membrane structure.

### SUMMARY OF THE INVENTION

The present invention has been made in view of the foregoing point, and it is an object to provide a method capable of easily manufacturing a radio frequency circuit of a membrane structure type.

A manufacturing method for a radio frequency circuit of the present invention is a method for manufacturing a radio frequency circuit comprising: a first step of forming a circuit by using an insulating material having metal, such as copper, bonded on both surfaces or one surface; a second step of bonding together a metal substrate having a hollow bore and the circuit made in the first step; a third step of mounting an active element on the circuit; and a fourth step of connecting the circuit made in the third step with a lid having a partition wall.

The partition wall provided on the lid is formed in an outer periphery of the lid to surround the radio frequency circuit. The interior of the lid is filled with vacuum, an inert gas or a nitrogen gas, as required.

The metal substrate is formed with a convex projection having a hollow bore at an inside thereof, as required.

The insulating material, preferably, has a dielectric loss tangent value of 0.003 or smaller at 1 GHz.

Another method for manufacturing a radio frequency circuit of the invention comprises: a first step of blanking a metal substrate with a die to form a hollow bore; a second step of carrying out a surface treatment or cleaning with a plasma or ozone on a metal small plate blanked by a die; a third step of inserting the surface-treated metal small plate into the hollow bore of the metal substrate; and a fourth step of placing an insulating material forming a circuit onto the metal substrate and thereafter hot-press it for bonding.

### BRIEF DESCRIPTION OF THE DRAWINGS

Fig. 1 is a sectional view of a radio frequency circuit in a membrane structure using a conventional metal-core substrate;
Fig. 2 is a sectional view showing a radio frequency circuit according to a first embodiment of the present invention;
Fig. 3 is a plan view of a radio frequency circuit, removed of a lid, according to the first embodiment of the invention, wherein Fig. 3A is a plan view of the lid as viewed from below while Fig. 3B is a plan view of the radio frequency circuit removed of the lid;
Fig. 4 is a perspective view of the lid of the radio frequency circuit according to the first embodiment of the invention;
Figs. 5A - 5D are a sectional view showing a circuit manufacturing process for a radio frequency circuit according to the first embodiment of the invention;
Fig. 6 is a sectional view of a radio frequency circuit according to a second embodiment of the invention;
Fig. 7 is a sectional view of a radio frequency circuit according to a third embodiment of the invention;
Fig. 8 is a sectional view of a radio frequency circuit according to a fourth embodiment of the invention;
Fig. 9 is a sectional view of a radio frequency circuit according to a fifth embodiment of the invention;
Fig. 10 is a perspective view of a lid of the radio frequency circuit according to the fifth embodiment of the invention;
Fig. 11 is a sectional view of a radio frequency circuit according to a sixth embodiment of the invention;
Fig. 12 is a perspective view of the radio frequency circuit on a bottom-surface side according to a sixth embodiment of the invention;
Fig. 13 is a sectional view of the radio frequency circuit according to the sixth embodiment of the invention upon being connected with another radio frequency circuit;
Figs. 14A - 14F are a sectional view showing a process of a radio frequency circuit manufacturing method according to a seventh embodiment of the invention;
Figs. 15A - 15F are a sectional view showing a process of a radio frequency circuit manufacturing method according to an eighth embodiment of the invention;
Figs. 16A - 16E are a sectional view showing a process of a radio frequency circuit manufacturing method according to a ninth embodiment of the invention; and
Figs. 17A - 17E are a sectional view showing a process of a radio frequency circuit manufacturing method according to a tenth embodiment of the invention.

### DESCRIPTION OF THE EXEMPLARY EMBODIMENT

Exemplary embodiments of the present invention are demonstrated hereinafter with reference to the accompanying drawings.

### 1. First Exemplary Embodiment

Fig. 2 shows an example of a radio frequency circuit fabricated by using a manufacturing method for a radio frequency circuit according to the present invention. A metal substrate 1 is of copper, copper-containing alloy or aluminum having a thickness of 100 µm or greater, generally 500 µm or greater, on which an insulating plate 2 is formed. The insulating plate 2 is formed of an insulating material having a low dielectric loss (dielectric loss of nearly 0.05 or less). In the case of fabricating a radio frequency circuit for a high-frequency band application of a microwave or millimeter-wave band, the insulating plate 2 preferably has, as a material characteristic, a dielectric loss tangent value of approximately 0.003 or less at a measuring frequency of 1 GHz. Where the value is greater, there is difficulty in structuring a useful circuit as a high frequency circuit for a high-frequency range application of a microwave or millimeter-wave band to which the invention is assumably applied, from a viewpoint of dielectric loss. For example, a glass-epoxy-based insulating material called FR-4, a general circuit-substrate insulation material, has a dielectric loss tangent of approximately 0.02 at a measuring frequency of 1 GHz. This is not preferred as an insulating material for fabricating a high-frequency circuit on a microwave or millimeter-wave band. Consequently, the insulating plate 2 is selected of a material having a low dielectric loss characteristic (low dielectric loss tangent) such as polyimide, teflon, liquid-crystal polymer or benzocyclo butene, in order to reduce the dielectric loss over a transmission line.

The insulating plate 2 has transmission lines 3, such as micro-strip lines, coplanar-strip lines, slot lines or ground lines, formed on the both surface thereof. Meanwhile, the insulating plate 2 is formed with hollow bores buried by a conductor. Thus, through-holes 4 are formed to connect between the transmission lines 3 on the opposite surfaces of the insulating plate 2 in an electrical, thermal conductive fashion. The metal substrate 1 has a hollow bore 5 serving as a waveguide to provide a membrane structure. The transmission line 3, on the upper surface of the insulating plate 2, has a high-frequency circuit pattern to arrange, thereon, active elements 6 such as MMICs (millimeter-wave (or microwave) monolithic integrated circuits), HBTs (hetero-junction bipolar transistors) or HEMTs (high electron mobility transistors). The active element 6 and the transmission line 3 are connected through a wire 7, to constitute a desired high-frequency circuit. A lid 8, covering over the high-frequency circuit for the purpose of electromagnetic shield, is bonded on the transmission line 3 on the upper surface of the insulating plate 2. The portion of the transmission line 3 extending outside the lid 8 provides a connection terminal to an external device.

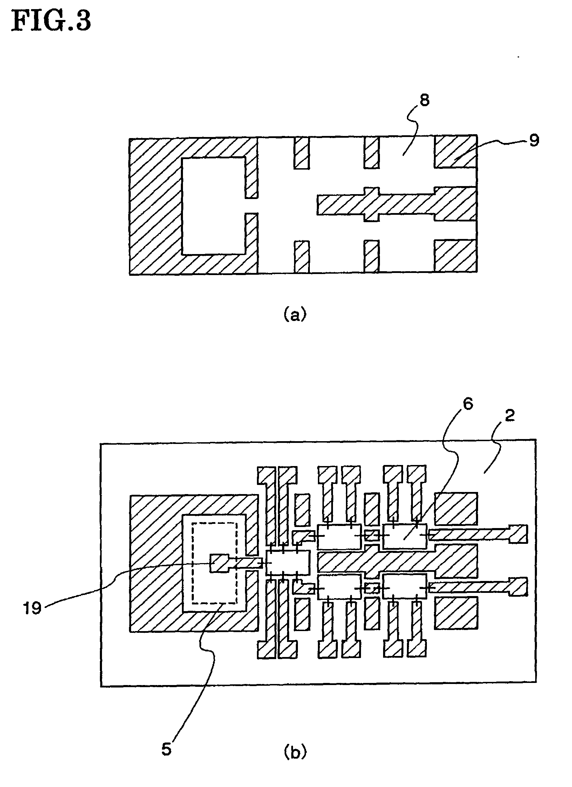

Fig. 3A is a plan view of the radio frequency circuit shown in Fig. 2 when removed of the lid 8, as viewing the radio frequency circuit from the below. Fig. 3B is a plan view of the radio frequency circuit removed of the lid 8, as viewed from the above. The hatched area shows the transmission line 3 of Fig. 2 while the dotted line 5 shows that the hollow bore 5 formed in the metal plate 1 of Fig. 2 exists in a region below the insulating plate 2. The hollow bore 5 as a waveguide, the slot line 19 and the lid 8 constitute a waveguide-planar line converting circuit.

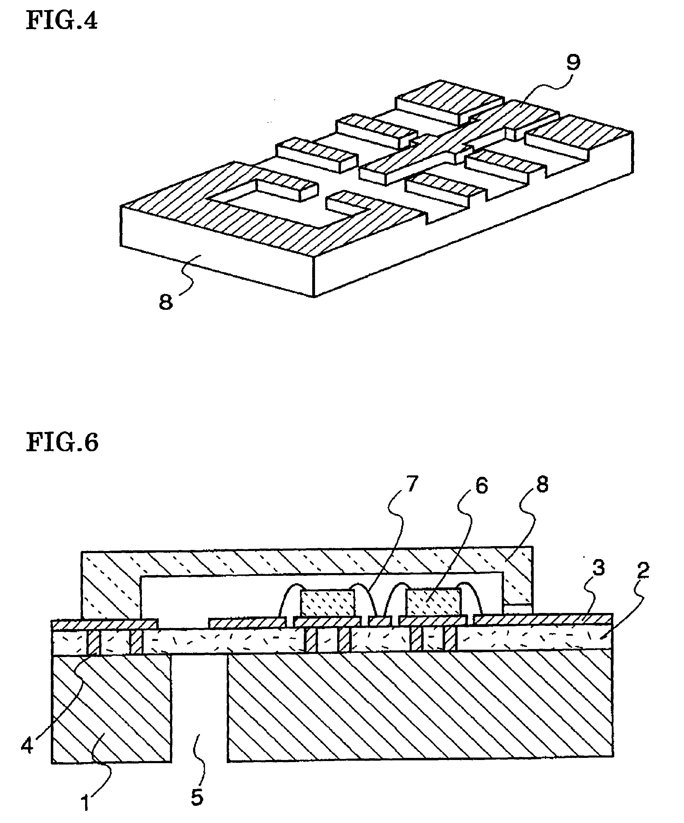

The lid 8 of Fig. 3A is shown, as a perspective view, in Fig. 4. The hatched area, in Figs. 3A and 4, is an area to be directly contacted with the radio frequency circuit of Fig. 3B. This area structures a partition wall 9 corresponding to the transmission line 3 and active element 6. The partition wall 9 particularly serves to suppress against the unwanted radio wave released from the active element 6. Besides the prevention of emission of unwanted radio wave toward an outside of the radio frequency circuit, it is possible to prevent the mutual interference of radio waves between the active elements 6. Thus, reliability can be improved for the entire radio frequency circuit.

Meanwhile, by arranging a radio-wave absorber in a bottom surface of the partition wall 9 as required, although not shown, the reliability can be further improved for the radio frequency circuit.

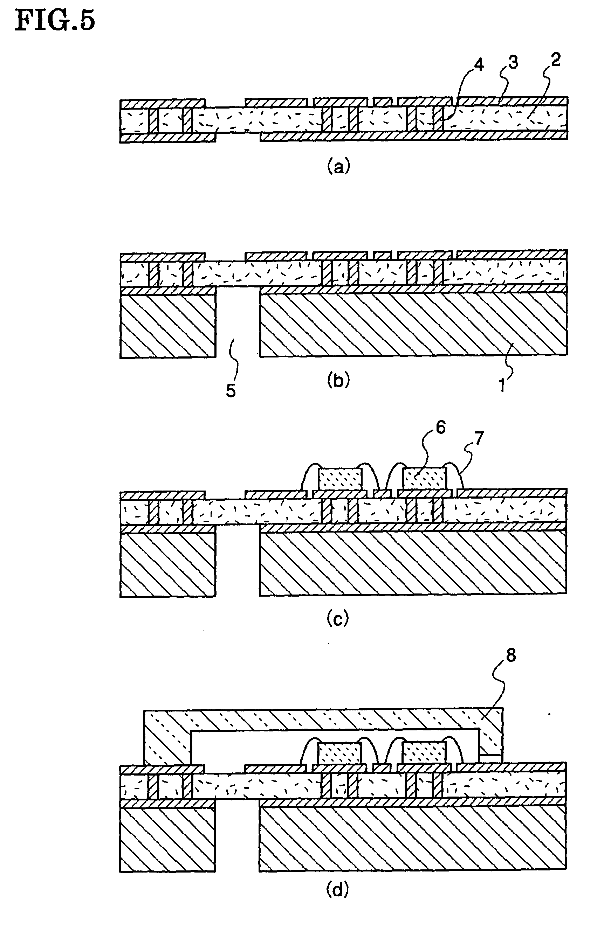

Now, explanation is made on a manufacturing method for a radio frequency circuit explained in Figs. 2 - 4, with reference to Figs. 5A - 5D.

Fig. 5A shows a process for manufacturing a circuit substrate by forming transmission lines 3 on the both surfaces of a low-loss insulating plate 2 and through-holes 4 formed with a conductor for electrically, thermal conductively connecting between the transmission lines 3 on the both surfaces. The insulating plate 2 and the transmission lines 3 use a sheet-formed material marketed called a lamination plate bonded with copper at both surfaces. This is opened by penetration holes in positions corresponding to through-holes 4 by drilling, laser or etching, and buried by a connection conductor in the penetration holes, thereby forming through-holes 4.

Fig. 5B shows a process for bonding a circuit substrate fabricated by the process of Fig. 5A onto a metal substrate 1 previously formed with a hollow bore 5. The method for forming a hollow bore 5 in the metal substrate 1 may use machining with the use of milling or press-blanking. The method using press-blanking is most effective in respect of working efficiency.

The method for bonding the circuit substrate made in the process of Fig. 5A and the metal substrate 1 together may use a bonding process using an adhesive or bonding agent high in electrical or thermal conductivity. Otherwise, these may be bonded directly or through a thermo-plastic or thermo-set film having electrical or thermal conductivity by the application of heat and pressure.

By thus separately fabricating a metal substrate 1 having a hollow bore 5 and a circuit substrate to bond them together, it is possible to form a desired form of hollow bore 5 in the metal substrate in a short time. Besides, because etching is not required, it is possible to greatly reduce the time required in fabricating a radio frequency circuit.

Fig. 5C shows a process for electrically connecting an active element 6 onto the transmission line 3 by a wire-bonding technique. Incidentally, the electrical connection between the active element 6 and the transmission line 3 may use a flip-chip mounting scheme instead of the wire-bonding technique.

Fig. 5D shows a process for bonding the lid 8 onto the circuit substrate. Although the bonding may be by a similar method to the foregoing bonding of between the circuit substrate and the metal substrate 1, the effective bonding method, above all, is to apply a paste epoxy-based adhesive agent to the partition wall 9, a hatched area, of the lid 8 shown in Fig. 4 by the use of a dispenser and then thermally cure it after bonding.

In this manner, Embodiment 1 can fabricate, by a simple way, a membrane-structured radio frequency circuit in a precise form posed as a problem in using a metal core substrate. Also, the efficiency can be enhanced in fabricating a radio frequency circuit.

The radio frequency circuit made by the manufacturing method can be used in a radio terminal, base-station apparatus, radio measuring apparatus, radar apparatus or the like. Thus, a reliable apparatus is to be obtained.

### 2. Second Exemplary Embodiment

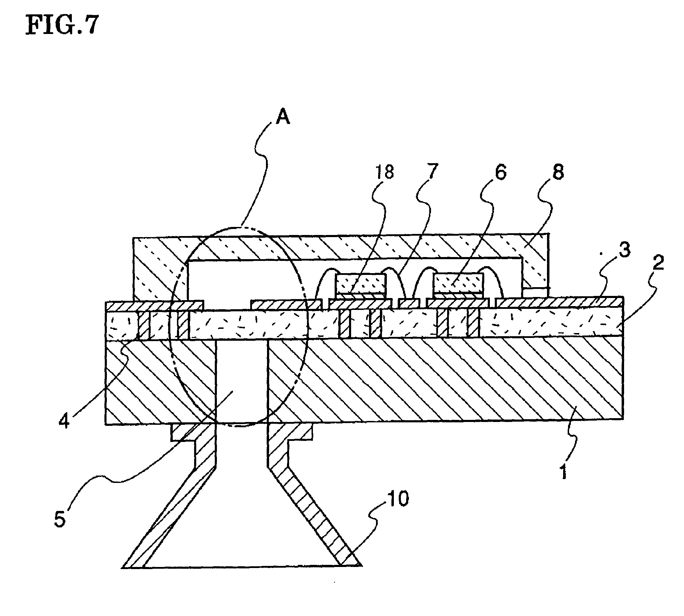

Fig. 6 shows an example of a sectional structure of a radio frequency circuit according to Embodiment 2 of the invention. The radio frequency circuit of Embodiment 2 is an example that a transmission line 3 is grounded to a metal substrate 1 by through-holes 4. The difference from the radio frequency circuit shown in Fig. 2 lies in that no transmission line 3 exists between the metal substrate 1 and the insulating plate 2. The manufacturing method is similar to that of Embodiment 1 excepting that a lamination plate bonded with copper at one surface is used in place of a lamination plate bonded with copper at both surfaces explained in Fig. 5A, and hence omittedly explained.

### 3. Third Exemplary Embodiment

Fig. 7 shows an example of a sectional structure of a radio frequency circuit according to Embodiment 3 of the invention. In Fig. 7, the same elements as those of Fig. 6 are denoted by the same reference numerals, and omittedly explained. In this embodiment, the active element 6 is bonded on the transmission line 3 through a conductive adhesive agent 18. An antenna 10 inputs and outputs a radio wave to and from an outside of the apparatus. The region A in the figure coupled to the antenna 10 constitutes a waveguide-planar line converter. The region A is in a form having a dielectric material 2 above a hollow bore 5. This structure is generally called a membrane structure. The transmission line 3 is electrically connected to a metal substrate 1 as a conductor through a through-hole 4. In this case, the metal substrate 1 serves as a ground of the transmission line 3. Meanwhile, the heat generated by the active element 6 diffuses through the through-hole 4 to the metal substrate 1. The metal substrate 1 serves as a dissipater of heat to the outside, thus having a function to cool down a microwave or millimeter-wave device including the waveguide-plane line converter.

The radio frequency circuit shown in Fig. 7, if having the antenna 10 connected at the region of the hollow hole 5, can structure a waveguide-planar line converter size-reduced in the entire circuit.

### 4. Fourth Exemplary Embodiment

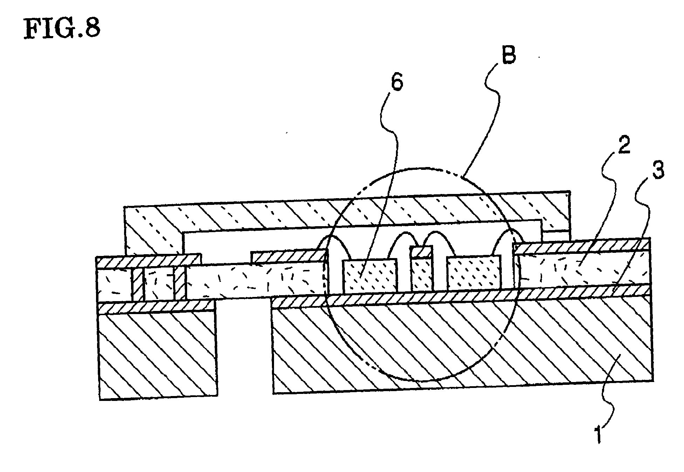

Fig. 8 shows an example of a sectional structure of a radio frequency circuit according to Embodiment 4 of the invention. This is a circuit nearly equivalent to the circuit shown in Fig. 2 but different from Fig. 2 in that the region shown at B, or active element 6, is directly contacted with a transmission line 3 of beneath an insulating material 2. The radio frequency circuit of a structure shown in Fig. 8 can structure a radio frequency circuit having a high heat dissipation effect because the heat generated from the active element 6 is allowed to dissipate directly at the transmission line 3 or through the metal substrate 1. The manufacturing method for this radio frequency circuit is similar to the manufacturing method explained in Embodiment 1 excepting that a hollow bore for an active element 6 is provided in place of the through-hole 4 in the process of Fig. 5A and an active element 6 is provided in the hollow bore in the process of Fig. 5C.

According to Embodiment 4, it is possible to fabricate, by a simple way, a precise-formed membrane-structured radio frequency circuit excellent in heat dissipation characteristic.

### 5. Fifth Exemplary Embodiment

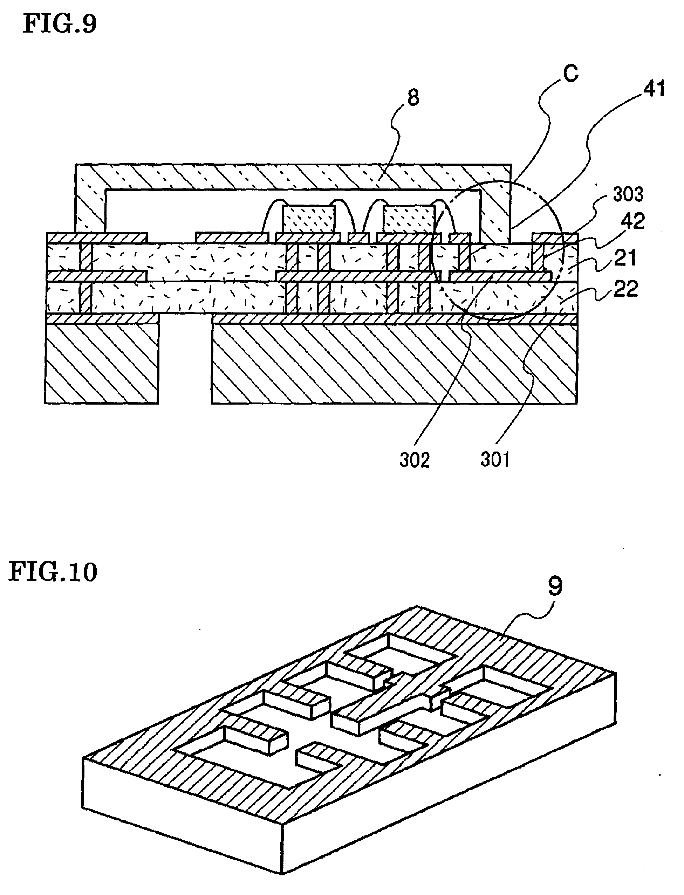

Fig. 9 shows an example of a sectional structure of a radio frequency circuit according to Embodiment 5 of the invention. This is a circuit nearly equivalent to the circuit shown in Fig. 2 but different from Fig. 2 in a part shown at C. Fig. 9 is different from Fig. 2 in that insulating materials 21, 22 are in a two-layer form, transmission lines 301, 302, 303 are in a three-layer form and a partition wall 9 formed on the lid 8 has a peripheral form extending over the entire periphery of the lid 8 as in a perspective view of Fig. 10.

By making the insulating material 2 in a two-layer structure, an internal transmission line 3 covered by the lid 8 is extended to a transmission line 303 outside the lid 8 through a through-hole 41, a transmission line 302 on a lower insulating material 22 and a through-hole 42, thus being extended to the outside without contact with the lid 8. Consequently, the lid 8 at its entire periphery can be provided as a surface to be directly bonded to the radio frequency circuit. By making vacuum at an inside of the recess of the lid 8 or filling an inert gas such as argon (Ar) or nitrogen (N₂) therein, the radio frequency circuit is shielded from the outside air. This can prevent the active elements 6 from deteriorating due to aging by the reaction with oxygen or humidity of the air. For the manufacturing method for a radio frequency circuit, the circuit manufacturing method shown in Figs. 5A - 5D is to be applied without change.

According to Embodiment 5, it is possible to provide a reliable, precise-formed radio frequency circuit of a membrane structure.

### 6. Sixth Exemplary Embodiment

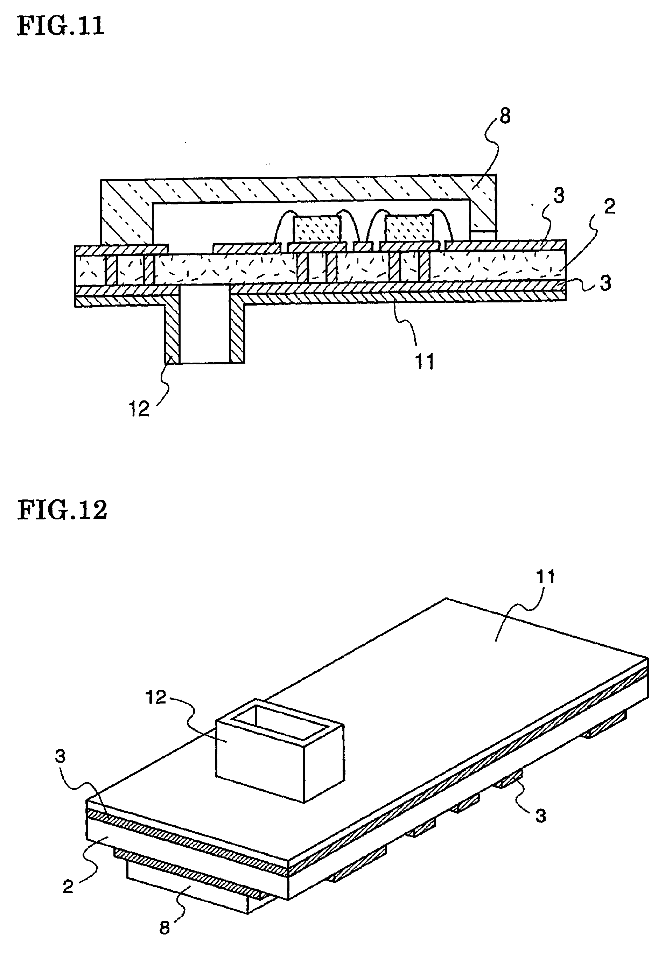

Fig. 11 shows an example of a sectional structure of a radio frequency circuit according to Embodiment 6 of the invention. This is a circuit nearly equivalent to the circuit shown in Fig. 2 but different in that a convex part 12 is formed in a metal substrate 11 in a membrane region of a radio frequency circuit. Fig. 12 is a perspective view of Fig. 11 as viewed from a bottom side. The manufacturing method for a metal substrate 11 having a convex part 12, although to be achieved by machining with cutting or etching, can use deep drawing by using press with excellence in respect of material use efficiency and operation time efficiency. The radio frequency circuit manufacture in the other process is similar to that of Figs. 5A - 5D.

The radio frequency circuit structured with the metal substrate 11 shown in Figs. 11 and 12 is in a structure convenient for connection to another radio frequency circuit device.

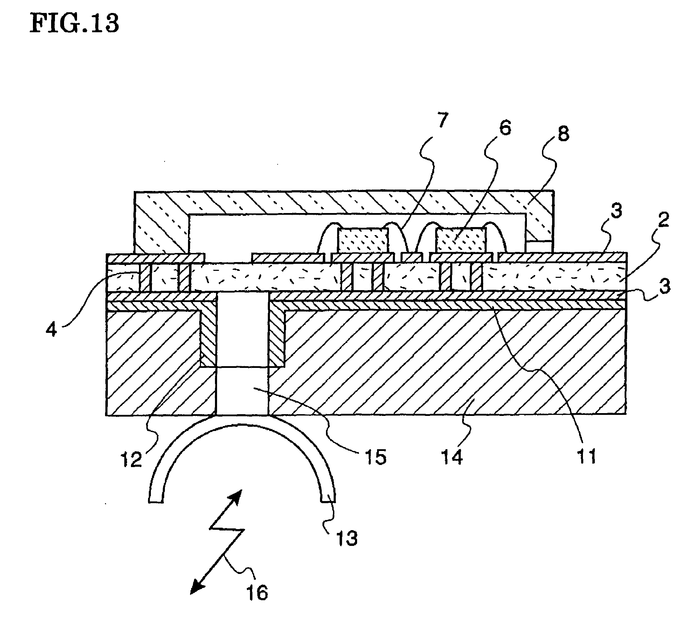

Fig. 13 is a view showing an example of a form that the radio frequency circuit shown in Fig. 11 is connected with another radio frequency circuit. The radio frequency circuit to be connected comprises an antenna 13 and a connection housing 14 built with a waveguide region 15. The connection housing 14 is connected to the metal substrate 11 such that a convex part 12 of the metal substrate 11 is coupled to a waveguide 15 of the housing 14. This allows the metal substrate 11 to operate as a part of a waveguide for a radio wave 16 to be inputted or outputted at the antenna 13.

In this case, the circuit in a membrane structure, for a radio wave 16 transmitted and received at the antenna 13, serves as a waveguide-planar circuit converting device that converts the waveguide 15 into a planar circuit structured by an insulating material 2, a transmission line 3, a through-hole 4, an active element and a lid 8.

In this manner, Embodiment 6 facilitates the connection with another radio frequency element part as shown in the example of Fig. 13, thus achieving size-reduction in the entire circuit.

### 7. Seventh Exemplary Embodiment

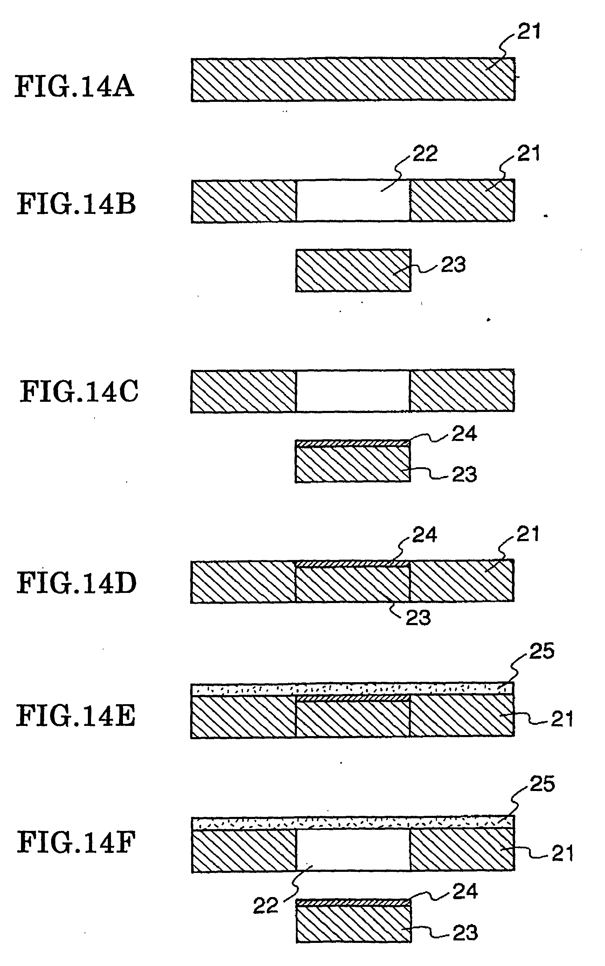

Figs. 14A - 14F show a part of a process of a radio frequency circuit manufacturing method for manufacturing a microwave or millimeter-wave device including a waveguide-planar line converter. This shows a process for manufacturing a membrane structure bonding a metal substrate and a dielectric material together.

Fig. 14A is a state having only a metal substrate 21. In Fig. 14B, a blanking penetration hole 22 is formed in the metal plate 21 by pressing using a die. Fig. 14C shows a state that a blanked metal small plate 23 is surface-treated at its upper surface to form a surface-treated layer 24. The surface-treated layer 24 is formed by applying a silicon-based or teflon-based surface treating material, or coating or evaporating an organic film of polyimide or the like. The surface treatment is for the purpose of making the metal small plate 23 having the surface-treatment layer 24 less bondable to a dielectric material during bonding between the dielectric material and the metal substrate in the later process. Fig. 14D shows a process of inserting the metal small plate 23 formed with the surface-treatment layer 24 into the penetration hole 22 of the metal substrate 21. Fig. 14E shows a process of hot-pressing a dielectric material 25 and bonding it onto the metal substrate 21. At this time, because of the presence of the metal small plate 23, the dielectric material 25 can be formed without flowing into the penetration hole 22 existing in the metal substrate 21.

It is requisite that the dielectric material 25 used in this process be reduced in dielectric loss because the invention is applied for a high frequency range of a microwave or millimeter-wave band. Selected is a material having a property of low dielectric loss (low dielectric loss tangent), such as polyimide, teflon, polymer of polyimide and teflon, liquid-crystal polymer or benzocyclo butene.

Fig. 14F is a process of taking the metal small plate 23 having the surface-treatment layer 24 out of the metal substrate 21. The metal small plate 23, because of surface-treated, can be easily removed from the metal substrate 21 without being bonded to the dielectric material 25.

By carrying out the process shown in Figs 14A - 14F, a dielectric material 25 is formed on the metal substrate 21 having the penetration hole 22. This makes it possible to manufacture a favorably shaped membrane structure and hence a small-sized, high-function microwave or millimeter-wave device.

### 8. Eighth Exemplary Embodiment

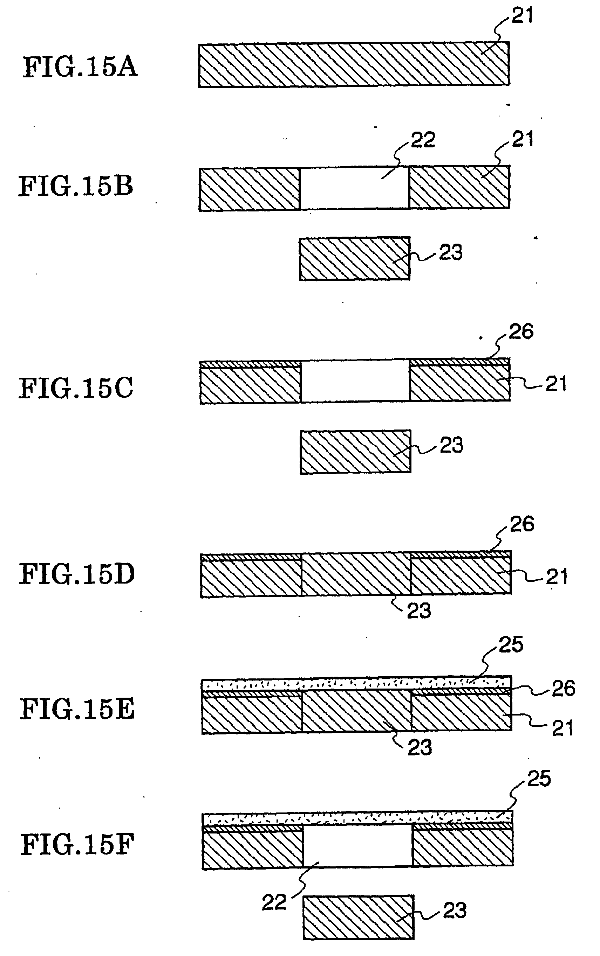

Figs. 15A - 15F show a second method for manufacturing a membrane structure by bonding together a metal substrate 21 and a dielectric material 25. Figs. 15A and 15B are a process similar to that of Figs. 14A and 14B but different from Fig. 14 in the subsequent process. Fig. 15C is a process to carry out a plasma cleaning process or ozone cleaning process on a surface of the metal substrate 21. A treatment layer 26 is formed on the surface of the metal substrate 21 by the plasma cleaning or ozone cleaning process. The present inventor has found that, by carrying out a plasma cleaning or ozone cleaning process prior to hot-pressing the metal substrate 21 and dielectric material 25, the adhesion force between the metal substrate 21 and the dielectric material 25 after hot-pressing is to be by far improved. Furthermore, it has been confirmed that, by carrying out a plasma cleaning or ozone cleaning process also on a bonding surface of the dielectric material 25 to the metal substrate 21, the adhesion force can be improved furthermore. By utilizing this nature to carry out a plasma cleaning or ozone cleaning process only on the metal substrate 21 having the penetration hole 22 without surface-treating the metal small plate 23, it is possible to facilitate the separation of the metal small plate 22 from the metal substrate 21 in the process of Fig. 15F.

The plasma cleaning methods include an atmospheric pressure plasma scheme for directly radiating a plasma in the air, a parallel-plate plasma etching scheme for plasma processing in a vacuum, and a reactive ion etching scheme. The reactive plasma etching scheme is the highest in cleaning effect. The cleaning condition in using a reactive plasma etching scheme includes, as an example, a mixing ration of O₂ gas and CF₄ gas of 4 : 1, a gas total flow rate of 50 sccm, a vacuum degree of 20 Pa, an RF power (13.56 MHz) of 1.2 W/cm², and a plasma radiation time of 30 seconds. Under this condition, the adhesion force was secured between the metal substrate 21 and the dielectric material 25 in Fig. 15E. It can be considered that the reason of adhesion force improvement is because of the following. Namely, the pollutant of carbon or the like deposited on a surface of the metal substrate 21 due to exposure to the air could be removed away by the plasma.

Incidentally, an inductive coupling plasma etching scheme or the like may be used besides the reactive plasma etching scheme.

Besides the cleaning using a plasma, the cleaning using ozone is also effective. The cleaning using ozone refers to a method that, after placing a metal substrate and dielectric material to be cleaned within a container filled with O₂ gas, ultraviolet light is radiated to the O₂ gas to ozonize the O₂ gas and thereby activate it so that it is reacted with the deposit, such as carbon, on the metal substrate and dielectric material thereby removing the same.

Fig. 15D and the subsequent are a process nearly the same as that of Fig. 14D and the subsequent. Fig. 15D shows a process of returning the metal small plate 23 to the metal substrate 21, Fig. 15E a process of bonding the metal substrate 21 and the dielectric material 25 together by hot-press, and Fig. 15F a process of taking out the metal small plate 23. In Fig. 15F, the metal substrate 21 is not done with a plasma cleaning or ozone cleaning process and hence can be easily separated without bonding to the dielectric material 25.

### 9. Ninth Exemplary Embodiment

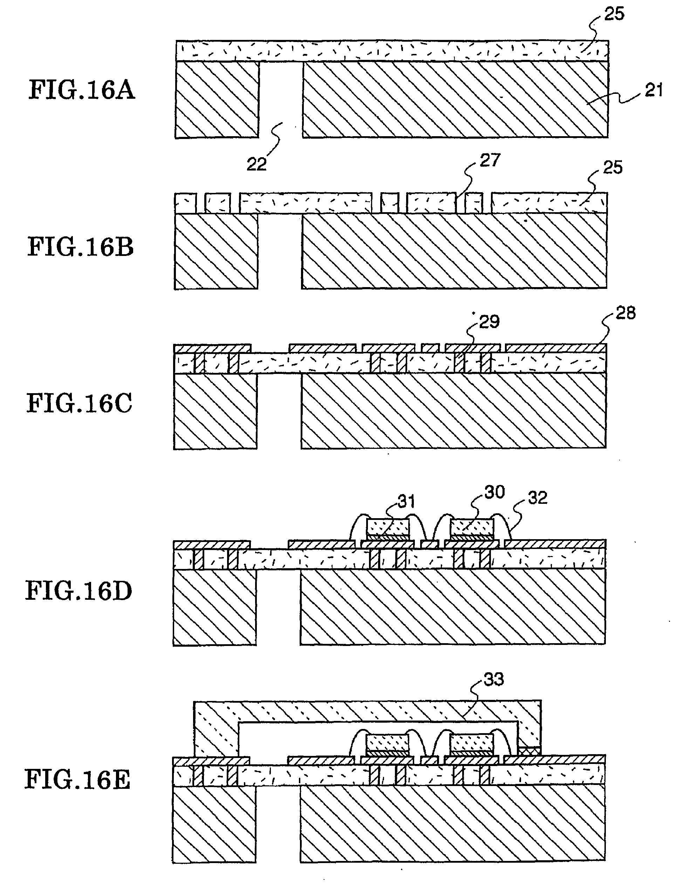

Fig. 16A - 16E are a process view of a manufacturing method for a radio frequency circuit according to Embodiment 9 of the invention. Fig. 16A is a membrane structure manufactured by the method of Embodiment 7 or 8. Fig. 16B shows a process of forming a penetration hole 27 for a through-hole in a dielectric material 25. The forming method for a penetration hole 27 preferably uses the laser working having a laser oscillation wavelength of ultraviolet light. This is because a through-hole diameter of 0.03 mm or smaller is difficult to realize by drilling. Meanwhile, dry etching has an etching rate of approximately 0.5 - 2 µm/min so that, when a dielectric material is 100 µm, it takes a working time of 50 - 200 minutes and mask forming process is further required. Accordingly, these are not to be considered as a practical forming method. In laser working, it is possible to carry out working by the use of a general carbon dioxide gas laser. However, the working using a carbon dioxide gas laser, as thermal working, has a defect to form a thermal deterioration layer in the dielectric film. On the other hand, in the laser working method having a laser oscillation wavelength of ultraviolet light such as in an excimer or YAG laser third harmonic, because ablation of a dielectric material is predominant in a working mechanism, it is possible to suppress thermal damage to the dielectric material.

Fig. 16C shows a process for forming a transmission line 28 including conductor formation in the penetration hole 27. The transmission line formation can be made by combining plating, metal film sputtering, resist forming/exposure/development, conductive paste forming and the like. The conductor formed in the penetration hole 27 forms a through-hole 29.

Fig. 16D shows a process of mounting an active element 30, such as a MMIC, HBT or HEMT. After forming a conductive adhesive 31 on the transmission line 28 (electrically not connected to another transmission line), an active element 30 is mounted thereon. The conductive adhesive 31 is hardened by thermal cure or the like. Electrical connection is made through a wire 32 to another transmission line 28.

Finally, a lid 33 as a shield is bonded by using a conductive paste, as shown in Fig. 16E.

### 10. Tenth Exemplary Embodiment

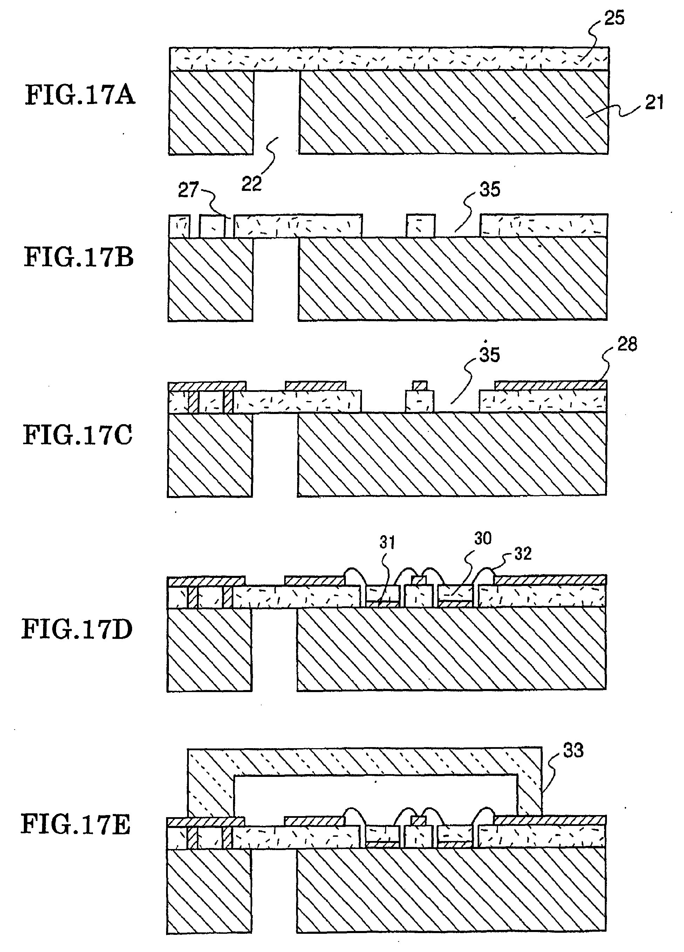

Fig. 17A - 17E is a radio frequency circuit manufacturing method similar in process to that shown in Fig. 16A - 16E but different in that an active element 30 is mounted directly on a metal substrate 21.

Fig. 17A is the same as Fig. 16A, which is in a membrane structure manufactured by the method of Embodiment 7 or 8. Fig. 17B shows a process of forming, in a dielectric material 25, a penetration hole 27 for a through-hole and a space 35 for mounting an active element 30. The forming method for a penetration hole 27 and space 35 preferably uses the laser working having a laser oscillation wavelength of ultraviolet light because of the reason explained in Embodiment 9.

Fig. 17C is a process of forming a transmission line 28 by the same method as Fig. 16C. Fig. 17D is a process of mounting an active element 30 directly on the metal substrate 21. The mounting method is the same as that of Fig. 16D.

By thus taking a form of mounting the active element 30 directly on the metal substrate 21, when making a microwave or millimeter-wave device including a waveguide-planar line converter, the heat generated by the active element 30 can be directly released to the metal substrate 21 having high thermal diffusibility. This provides a reliable microwave or millimeter-wave device. Meanwhile, by directly mounting the active element 30 on the metal substrate 21, the wire 32 can be substantially shortened, e.g. where the dielectric material 25 has a thickness of 100 µm and the active element 30 also has a thickness of 100 µm. By shortening the wire 32 length, circuit impedance modulation can be suppressed thereby making possible to manufacture a high-quality microwave or millimeter-wave device.

### 11. Eleventh Exemplary Embodiment

In Embodiment 1 - 10, the metal substrate 1, 11, 21 if using a material of copper or copper-containing alloy is effective in respect of environmental consideration. This is because copper can be readily recovered by the use of copper chloride or iron chloride. In recent years, electronic appliance recycling has being sought to push forward. The use of easily recoverable copper as a metal substrate can enhance the ability of recycling the microwave or millimeter-wave device including waveguide-planar line converter and the communication terminal, base-station apparatus, radio measuring apparatus and radar apparatus using the same device.

Meanwhile, in the case of using copper as a material of the metal substrate 11 in Embodiment 6, deep drawing is easily possible owing to high copper malleability.

## Claims

1. A method for manufacturing a radio frequency circuit having a membrane structure, the manufacturing method comprising:
a step of forming a hollow bore in a metal substrate;
a step of forming a circuit element on an insulating material plate having copper bonded on both surfaces or one surface thereof;
a step of bonding together the metal substrate having a hollow bore and the insulating material plate formed with a circuit element;
a step of mounting an active element on the circuit element; and
a step of bonding a lid having a partition wall onto the circuit mounting an active element.

2. A method for manufacturing a radio frequency circuit according to claim 1, wherein the step of forming a circuit element on an insulating material plate has
a step of forming a circuit pattern on an insulating material plate having copper bonded on both surfaces or one surface,
a step of forming a penetration hole in a position corresponding to a through-hole, and
a step of burying a connection conductor in the penetration hole to form a through-hole.

3. A method for manufacturing a radio frequency circuit according to claim 2, further comprising a step of forming a hollow bore in a position for mounting an active element.

4. A method for manufacturing a radio frequency circuit according to claim 2, wherein the step of forming a penetration hole in a position corresponding to a through-hole is by any one of ultraviolet-light laser working, drilling and dry etching.

5. A method for manufacturing a radio frequency circuit according to claim 3, wherein the step of forming a hollow bore in a position for mounting an active element is by any one of ultraviolet-light laser working, drilling and dry etching.

6. A method for manufacturing a radio frequency circuit having a membrane structure, the manufacturing method comprising:
a first step of blanking a metal substrate with a die to form a hollow bore;
a second step of carrying out a surface treatment on a metal small plate blanked in the first step;
a third step of inserting the metal small plate surface-treated in the second step into the hollow bore of the metal substrate; and
a fourth step of arranging an insulating material on the metal substrate and then bonding them together by hot press.

7. A method for manufacturing a radio frequency circuit according to claim 6, wherein the step of carrying out a surface treatment on a metal small plate is a step to apply a surface-treating material based on silicon or on teflon.

8. A method for manufacturing a radio frequency circuit according to claim 6, wherein the step of carrying out a surface treatment on a metal small plate is a step to coat or evaporate an organic film.

9. A method for manufacturing a radio frequency circuit according to claim 9, wherein the step of carrying out a surface treatment on a metal small plate is a step of cleaning with a plasma or ozone.

10. A membrane-structured radio frequency circuit comprising:
a circuit pattern including a transmission line formed on an insulating material plate having copper bonded on both surfaces or one surface thereof;
a circuit element having an active element mounted in a predetermined position of the circuit pattern;
a metal substrate having a hollow bore coupled to the circuit element; and
a lid coupled covering a predetermined position of the circuit element.

11. A radio frequency circuit according to claim 10, wherein the insulating material plate has one layer or two or more layers.

12. A radio frequency circuit according to claim 10, comprising a partition wall in an outer periphery of the lid to surround the radio frequency circuit.

13. A radio frequency circuit according to claim 10, wherein the metal substrate is in a form having a convex projection having a hollow bore at an inside thereof.

14. A radio frequency circuit according to claim 10, further comprising a waveguide formed in the hollow bore region and an antenna coupled to the waveguide.

15. A radio frequency circuit according to claim 10, comprising a second radio frequency circuit connected to the radio frequency circuit, the second radio frequency circuit having a connection housing incorporating an antenna and a waveguide part, the waveguide part of the connection housing being connected to be coupled to the convex projection of the metal substrate.

16. A radio frequency circuit according to claim 10, wherein the insulating material plate has a dielectric loss tangent of 0.003 or less at 1 GHz.

17. A radio frequency circuit according to claim 10, wherein the insulating material plate is any of liquid crystal polymer, benzocyclo butene, teflon-containing polyimide.

18. A radio frequency circuit according to claim 10, wherein a material of the metal substrate is copper or copper-containing alloy.

19. A radio frequency circuit according to claim 10, wherein an inside of the lid is in a vacuum state or filled with an inert gas or nitrogen gas.

20. A radio terminal apparatus having a membrane-structured radio frequency circuit comprising:
a circuit pattern including a transmission line formed on an insulating material plate having copper bonded on both surfaces or one surface thereof;
a circuit element having an active element mounted in a predetermined position of the circuit pattern;
a metal substrate having a hollow bore coupled to the circuit element; and
a lid coupled covering a predetermined position of the circuit element.

21. A radio base station apparatus having a membrane-structured radio frequency circuit comprising:
a circuit pattern including a transmission line formed on an insulating material plate having copper bonded on both surfaces or one surface thereof;
a circuit element having an active element mounted in a predetermined position of the circuit pattern;
a metal substrate having a hollow bore coupled to the circuit element; and
a lid coupled covering a predetermined position of the circuit element.

22. A radio measuring apparatus having a membrane-structured radio frequency circuit comprising:
a circuit pattern including a transmission line formed on an insulating material plate having copper bonded on both surfaces or one surface thereof;
a circuit element having an active element mounted in a predetermined position of the circuit pattern;
a metal substrate having a hollow bore coupled to the circuit element; and
a lid coupled covering a predetermined position of the circuit element.

23. A radar apparatus having a membrane-structured radio frequency circuit comprising:
a circuit pattern including a transmission line formed on an insulating material plate having copper bonded on both surfaces or one surface thereof;
a circuit element having an active element mounted in a predetermined position of the circuit pattern;
a metal substrate having a hollow bore coupled to the circuit element; and
a lid coupled covering a predetermined position of the circuit element.
